# EUROPEAN PATENT APPLICATION

(11) **EP 4 120 365 A1**
(43) Date of publication of application: **18.01.2023**
(21) Application number: 21904634.9
(22) Date of filing: 24.09.2021
(51) Int. Cl.: H01L 29/78, H01L 21/336

(54) **SEMICONDUCTOR DEVICE AND MANUFACTURING METHOD THEREFOR**

(30) Priority: 01.06.2021 CN 202110610067
(71) Applicant: Changxin Memory Technologies, Inc., Hefei City, Anhui 230601 (CN)
(72) Inventor: LEE, Tzung-Han, Hefei City, Anhui 230601 (CN)
(74) Representative: V.O.
(86) International application number: PCT/CN2021/120235
(87) International publication number: WO 2022/252445

(57) **Abstract**

The embodiments of the present disclosure provide a semiconductor device, including: an active area that is located in a semiconductor substrate and includes a central area and a peripheral area surrounding the central area; a first strained layer that is formed in the peripheral area in an embedded manner, and includes at least a first sub-portion, a second sub-portion, a third sub-portion, and a fourth sub-portion, where the first sub-portion and the third sub-portion are separately arranged on two sides of the central area in a first direction, and the second sub-portion and the fourth sub-portion are separately arranged on the other two sides of the central area in a second direction, where the first direction is different from the second direction; and a gate that is located on the active area, extends in a first direction and covers at least a part of the central area, at least a part of the first sub-portion, and at least a part of the third sub-portion.

## Description

### CROSS-REFERENCE TO RELATED APPLICATION

This application is submitted based upon and claims priority to Chinese patent application No. 202110610067.7 filed on June 1, 2021, the disclosure of which is hereby incorporated by reference in its entirety.

### TECHNICAL FIELD

The present disclosure relates to, but is not limited to, a semiconductor device and a method for manufacturing the same.

### BACKGROUND

With the continuous reduction of the size of microelectronic devices, the low mobility of silicon material has become the main factor that restricts the performance of microelectronic devices.

It has been found that the mobility of carriers can be improved by arranging strained layers in semiconductor substrates. However, if the location of the strained layer is different, the mobility of the carriers is different. Hence, how to arrange the strained layer to obtain a higher mobility of the carriers becomes a research hotspot of the semiconductor manufacturers.

### SUMMARY

Embodiments of the present disclosure provide a semiconductor device, including: an active area, a first strained layer and a gate.

The active area is located in a semiconductor substrate and includes a central area and a peripheral area surrounding the central area.

The first strained layer is formed in the peripheral area in an embedded manner, where the first strained layer includes at least a first sub-portion, a second sub-portion, a third sub-portion, and a fourth sub-portion. The first sub-portion and the third sub-portion are separately arranged on two sides of the central area in a first direction, and the second sub-portion and the fourth sub-portion are separately arranged on the other two sides of the central area in a second direction. The first direction is different from the second direction.

The gate is located on the active area, extends in a first direction and covers at least a part of the central area, at least a part of the first sub-portion, and at least a part of the third sub-portion.

The embodiments of the present disclosure further provide a method for manufacturing a semiconductor device, including the following operations.

A semiconductor substrate is provided, and an active area including a central area and a peripheral area surrounding the central area is defined in the semiconductor substrate.

A first strained layer is formed in the peripheral area in an embedded manner, where the first strained layer includes at least a first sub-portion, a second sub-portion, a third sub-portion, and a fourth sub-portion. The first sub-portion and the third sub-portion are separately arranged on two sides of the central area in a first direction, and the second sub-portion and the fourth sub-portion are separately arranged on other two sides of the central area in a second direction. The first direction is different from the second direction.

A gate extending in a first direction and covering at least a part of the central area, at least a part of the first sub-portion, and at least a part of the third sub-portion is formed on the active area.

### BRIEF DESCRIPTION OF THE DRAWINGS

FIGS. 1A and 1B are schematic diagrams of a semiconductor device provided in the related art.
FIGS. 2A-2C are schematic diagrams of a semiconductor device according to an embodiment of the present disclosure.
FIG. 3 is a schematic diagram of a central area and a peripheral area according to an embodiment of the present disclosure.
FIG. 4 is a schematic diagram of a semiconductor device having a ring-shaped first strained layer according to an embodiment of the present disclosure.
FIGS. 5A-5B are schematic diagrams of a semiconductor device having a second strained layer according to an embodiment of the present disclosure.
FIG. 6 is a schematic diagram of a semiconductor device having a first source/drain extension area and a second source/drain extension area according to an embodiment of the present disclosure.
FIG. 7 is a flowchart of a method for manufacturing a semiconductor device according to an embodiment of the present disclosure.
FIGS. 8A-8E are schematic diagrams illustrating a method for manufacturing a semiconductor device according to an embodiment of the present disclosure.

### DETAILED DESCRIPTION

The exemplary implementation modes disclosed in the present disclosure will be described in more detail below with reference to the accompanying drawings. While exemplary implementation modes of the present disclosure are shown in the accompanying drawings, it should be understood that the present disclosure may be implemented in various forms without being limited by the specific implementation modes set forth herein. Rather, these implementation modes are provided to enable a more thorough understanding of the present disclosure and to enable the full scope of the disclosure in the present disclosure to be communicated to those skilled in the art.

In the following description, a number of specific details are given to provide a more thorough understanding of the present disclosure. However, it will be apparent to those skilled in the art that the present disclosure may be implemented without one or more of these details. In other examples, some technical features known in the art are not described to avoid confusion with the present disclosure, that is, not all features of the actual embodiments are described herein, and well-known functions and structures are not described in detail.

In the accompanying drawings, the sizes of the layers, areas, elements and their relative sizes may be exaggerated for clarity. The same reference numerals denote the same elements throughout.

It should be understood that when an element or layer is referred to as being "on", "adjacent to", "connected to "or "coupled to" other elements or layers, it may be directly on, adjacent to, connected to or coupled to other elements or layers, or intervening elements or layers may be present. In contrast, when an element is referred to as being "directly on", "directly adjacent to", "directly connected to" or "directly coupled to" other elements or layers, there are no intervening elements or layers. It should be understood that although the terms first, second, third, etc. may be used to describe various elements, components, areas, layers and/or parts, these elements, components, areas, layers and/or parts should not be limited by these terms. These terms are only used to distinguish one element, component, area, layer or part from another element, component, area, layer or part. Therefore, without departing from the teachings of the present disclosure, the first element, component, area, layer or part discussed below may be represented as a second element, component, area, layer or part. When the second element, component, area, layer or part is discussed, it does not mean that the first element, component, area, layer or part is necessarily present in the present disclosure.

Spatial relation terms such as "below ...", "under ...", "lower", "beneath ...", "above ...", "upper", etc., can be used here for convenience of description to describe the relationship between one element or feature illustrated in the figures and other elements or features. It should be understood that in addition to the orientations illustrated in the figures, the spatial relationship terms are intended to include different orientations of devices in use and operation. For example, if the device in the drawings is turned over, then elements or features described as "below" or "under" or "beneath" other elements will be oriented "above" the other elements or features. Therefore, the exemplary terms "below" and "under" may include both an orientation of above and below. The device can be otherwise oriented (rotated by 90 degrees or in other orientations) and the spatial descriptors used here are interpreted accordingly.

The term used herein is intended only to describe specific embodiments and is not intended as a limitation of the present disclosure. As used herein, "a/an", "one" and "said/the" in the singular form are also intended to include the plural form unless clearly indicated otherwise in the context. It should also be understood that the terms "consist of" and/or "include", as used in this specification, determine the existence of the described features, integers, steps, operations, elements and/or components, but do not exclude the existence or addition of one or more other features, integers, steps, operations, elements, components, and/or groups. As used herein, the term "and/or" includes any and all combinations of related listed items.

It is known that the introduction of tensile stress in the channel of the N-type metal oxide semiconductor field effect transistor (NMOSFET) can improve the mobility of electrons in the channel, and the introduction of compressive stress in the channel of the P-type metal oxide semiconductor field effect transistor (PMOSFET) can improve the mobility of holes in the channel.

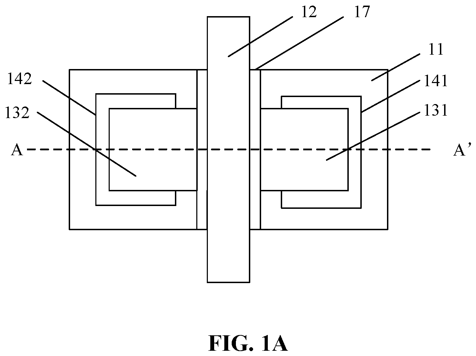

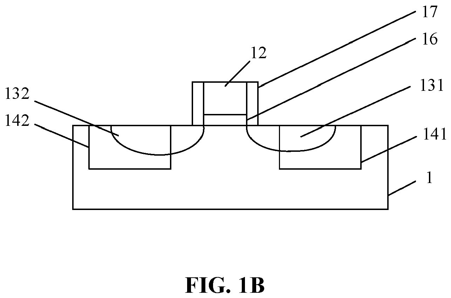

FIGS. 1A and 1B are schematic diagrams of a semiconductor device provided in the related art. FIG. 1B is a sectional view of FIG. 1A taken along the dashed line A-A'. As illustrated in FIGS. 1A-1B, the semiconductor device includes a semiconductor substrate 1 that includes an active area 11. A gate dielectric layer 16, a gate 12, and sidewalls 17 are formed on the active area 11. The active area 11 includes source/drain areas 131 and 132. The gate 12, the gate dielectric layer 16, the sidewalls 17, and the source/drain areas 131 and 132 constitute a MOS transistor.

Strained portions 141, 142 are further formed in the active area 11, which are positioned on both sides of the gate 12 to apply a stress to a channel below the gate 12 to increase the mobility of carriers in the channel.

However, the mobility of carriers in the channel of the semiconductor device provided in the above related art cannot meet the needs of modern integrated circuit technology development.

According to this, the following technical solutions in the embodiments of the present disclosure are proposed.

The embodiments of the present disclosure provide a semiconductor device, including an active area, a first strained layer, and a gate. The active area is located in the semiconductor substrate and includes a central area and a peripheral area surrounding the central area. The first strained layer is formed in the peripheral area in an embedded manner, where the first strained layer includes at least a first sub-portion, a second sub-portion, a third sub-portion, and a fourth sub-portion. The first sub-portion and the third sub-portion are separately arranged on two sides of the central area in a first direction, and the second sub-portion and the fourth sub-portion are separately arranged on the other two sides of the central area in a second direction. The first direction is different from the second direction. The gate is located on the active area, extends in a first direction and covers at least a part of the central area, at least a part of the first sub-portion, and at least a part of the third sub-portion.

The first strained layer provided by the embodiments of the present disclosure generates stress in both directions in the first direction and the second direction respectively on the channel below the gate. Therefore, with the first strained layer provided by the embodiments of the present disclosure, the mobility of the carriers in the channel can be further improved compared with the structure in which the stress is generated in only one direction in the above related art.

In order to make the above objectives, features and advantages of the present disclosure more apparent and understandable, the specific implementation modes of the present disclosure are described in detail below with reference to the accompanying drawings. When describing the embodiments of the present disclosure in detail, the schematic diagram is not partially enlarged according to the general scale for convenience of description, and the schematic diagram is merely an example, and is intended to limit the protection scope of the present disclosure.

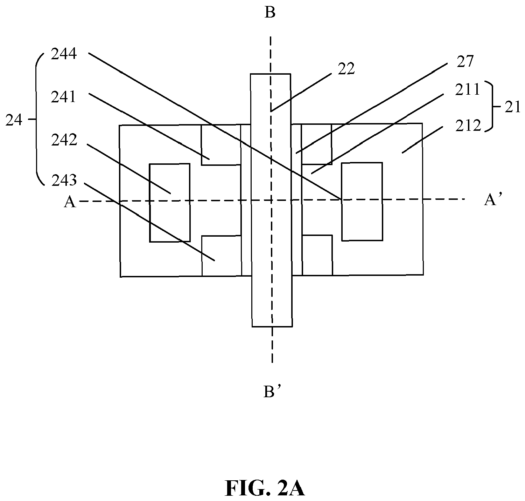

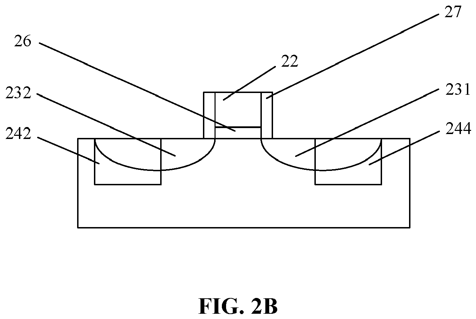

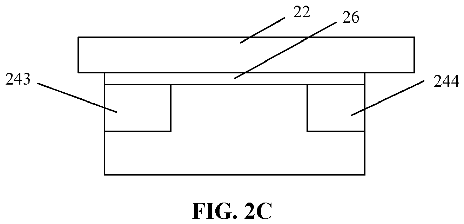

FIGS. 2A-2C are schematic diagrams of a semiconductor device according to an embodiment of the present disclosure. FIG. 2A is a top view of the semiconductor device, FIG. 2B is a sectional view of FIG. 2A along a dashed line A-A', and FIG. 2C is a sectional view of FIG. 2A along a dashed line B-B'. As illustrated in FIGS. 2A-2C, the semiconductor device includes an active area 21 located in a semiconductor substrate, in which the active area 21 includes a central area 211 and a peripheral area 212 surrounding the central area 211. A first strained layer 24 is formed in the peripheral area 212 in an embedded manner. The first strained layer 24 includes at least a first sub-portion 241, a second sub-portion 242, a third sub-portion 243, and a fourth sub-portion 244. The first sub-portion 241 and the third sub-portion 243 are separately arranged on two sides of the central area 211 in a first direction, and the second sub-portion 242 and the fourth sub-portion 244 are separately arranged on the other two sides of the central area 211 in a second direction. The first direction is different from the second direction.

The semiconductor device further includes a gate 22 located on the active area 21. The gate 22 extends in a first direction and covers at least a part of the central area 211, at least a part of the first sub-portion 241, and at least a part of the third sub-portion 243.

It can be understood that the parts of the first sub-portion 241 and the third sub-portion 243 covered by the gate 22 constitute a part of the channel; and the first sub-portion 241 and the third sub-portion 243 apply stress to the channel area in a first direction. In one embodiment, the first direction is parallel to the channel width direction (B-B' direction).

The second sub-portion 242 and the fourth sub-portion 244 apply stress to the channel area in a second direction. In one embodiment, the second direction is parallel to the channel length direction (A-A' direction).

In some embodiments, the second sub-portion 242 and the fourth sub-portion 244 are symmetrically distributed on both sides of the gate 22.

The material of the semiconductor substrate may be single crystal silicon (Si), silicon on insulator (SOI), or may be other materials, such as Group III-V compounds such as gallium arsenide.

The semiconductor substrate further includes a shallow trench isolation structure (not illustrated), which may be multiple. Multiple shallow trench isolation structures define the active area 21 in the semiconductor substrate.

A gate dielectric layer 26 is included between the gate 22 and the semiconductor substrate. The material of the gate dielectric layer 26 may be, for example, silicon oxide, but not limited thereto. Any material that may be used as the gate dielectric layer may be applied to the embodiments of the present disclosure.

In some embodiments, the gate 22 include sidewalls 27 at its both sides, the material of which may be silicon oxide, silicon nitride, but not limited thereto. Any material that may be used as the gate dielectric layer may be applied to the embodiments of the present disclosure.

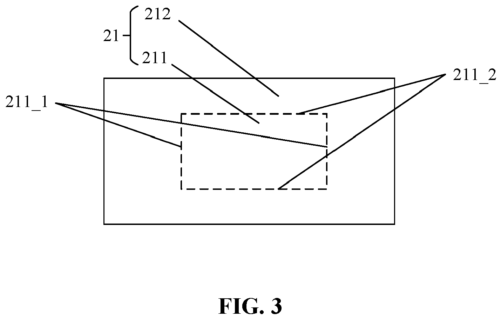

In some embodiments, the central area 211 is rectangular. FIG. 3 illustrates a schematic diagram of a central area and a peripheral area according to an embodiment of the present disclosure. As illustrated in the figure, the central area 211 includes a first set of parallel side edges 211_1 parallel to the first direction and a second set of parallel side edges 211_2 parallel to the second direction. It should be noted that, in some other embodiments, the central area 211 may also be in other shapes, such as circular, elliptical, or other polygons other than rectangular.

In some specific embodiments, the first sub-portion 241 and the third sub-portion 243 are symmetrical along the center line of the first set of parallel sides 211_1, and the second sub-portion 242 and the fourth sub-portion 244 are symmetrical along the center line of the second set of parallel sides 211_2.

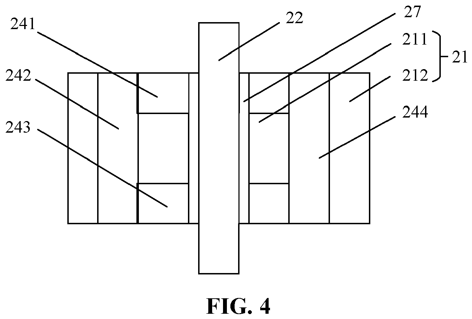

In some embodiments, the first sub-portion 241, the second sub-portion 242, the third sub-portion 243, and the fourth sub-portion 244 are sequentially connected to form a ring structure surrounding the central area 211, as illustrated in FIG. 4.

Specifically, both ends of the first sub-portion 241 are respectively connected in contact with one end of the second sub-portion 242, and both ends of the third sub-portion 243 are respectively connected in contact with the other end of the second sub-portion 242 and the other end of the fourth sub-portion 244. The first strained layer 24 having a ring structure can apply stress in both directions to the entire channel area, which can further optimize the performance of the semiconductor device compared to the first strained layer having a non-ring structure.

In one embodiment, the first strained layer 24 includes a silicon germanium layer. In this case, the stress generated by the first strained layer 24 to the channel is a compressive stress, the semiconductor substrate is an n-type substrate, and the semiconductor device is a PMOS transistor. It will be appreciated that the first strained layer 24 may also be other strained materials, such as silicon carbide or the like.

In one embodiment, the first strained layer 24 is formed using, but not limited to, an epitaxial growth process. The first strained layer 24 may also be formed using other processes such as doping the semiconductor substrate.

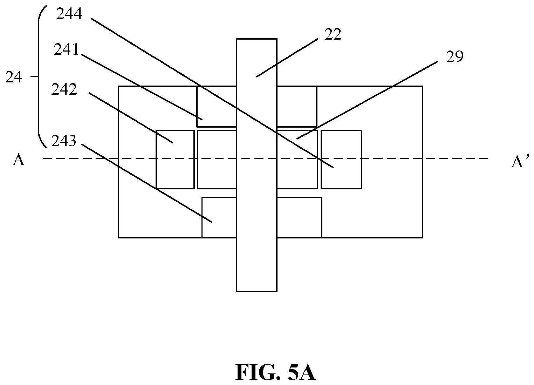

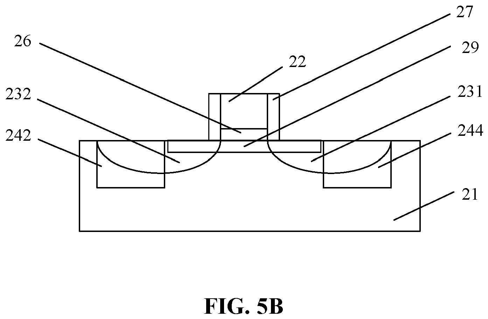

In some embodiments, the semiconductor device further includes a second strained layer 29 located in the central area 211. FIGS. 5A-5B illustrate schematic diagrams of a semiconductor device having a second strained layer according to an embodiment of the present disclosure. FIG. 5B illustrates a sectional view of FIG. 5A taken along a dashed line A-A'. As illustrated in FIGS. 5A-5B, a second strained layer 29 is formed in the center area 211. The second strained layer 29 further improves the mobility of carriers in the channel and thus improves the performance of the semiconductor device.

In a specific embodiment, the thickness of the first strained layer 24 is greater than the thickness of the second strained layer 29. In a more specific embodiment, the thickness of the first strained layer is 5-10 times, for example eight times, the thickness of the second strained layer.

In one embodiment, the second strained layer 29 and the first strained layer 24 are formed in a same process step.

In some embodiments, at least a part of the edges of the second strained layer 29 is connected to the edges of the first strained layer 24. In a more specific embodiment, all edges of the second strained layer 29 are connected to the first strained layer 24.

In one embodiment, the material of the second strained layer 29 is the same as the material of the first strained layer 24, but not limited thereto. The material of the second strained layer 29 may also be different from that of the first strained layer 24.

In one embodiment, the second strained layer 29 includes a silicon germanium layer. In this case, the stress generated by the second strained layer to the channel is a compressive stress, the semiconductor substrate is an n-type substrate, and the semiconductor device is a PMOS transistor.

In one embodiment, the second strained layer 29 is formed using, but not limited to, an epitaxial growth process. The second strained layer 29 may also be formed using other processes such as doping the semiconductor substrate.

Referring to FIG. 2B again, the semiconductor device further includes a first source/drain area 231 and a second source/drain area 232, which may be formed in the active area 21 by doping.

In some embodiments, the first source/drain area 231 at least partially coincides with the fourth sub-portion 244 and the second source/drain area 232 at least partially coincides with the second sub-portion 242. In a specific embodiment, the first source/drain area 231 completely coincides with the fourth sub-portion 244, and the second source/drain area 232 completely coincides with the second sub-portion 242.

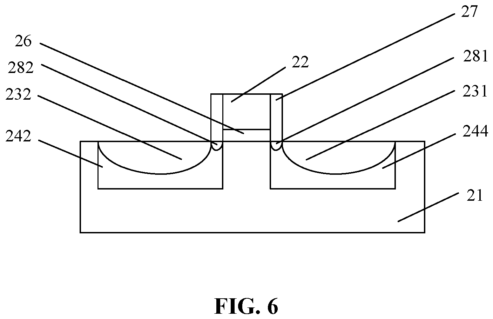

In some embodiments, the semiconductor device further includes a first source/drain extension area 281 having a doping depth less than that of the first source/drain area 231, as illustrated in FIG. 6. The first source/drain extension area 281 is located between the channel below the gate 22 and the first source/drain area 231, and at least partially coincides with the fourth sub-portion 244. The first source/drain extension area 281 can reduce the contact area between the first source/drain area 231 and the channel to reduce the leakage current in the channel.

In some embodiments, the semiconductor device further includes a second source/drain extension area 282 having a doping depth less than that of the second source/drain area 232, as illustrated in FIG. 6. The second source/drain extension area 282 is located between the channel below the gate 22 and the second source/drain area 232, and at least partially coincides with the second sub-portion 242. The second source/drain extension area 282 can reduce the contact area between the second source/drain area 232 and the channel to reduce the leakage current in the channel.

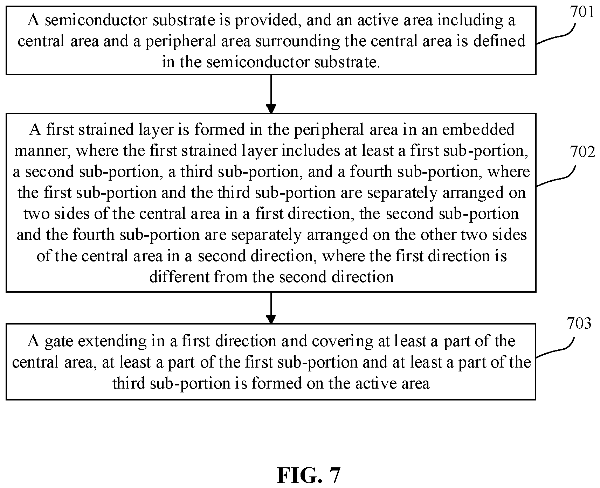

The embodiments of the present disclosure further provide a method for manufacturing a semiconductor device. As illustrated in FIG. 7, the method includes the following steps.

In Step 701, a semiconductor substrate is provided, and an active area including a central area and a peripheral area surrounding the central area is defined in the semiconductor substrate.

In Step 702, a first strained layer is formed in the peripheral area in an embedded manner, which includes at least a first sub-portion, a second sub-portion, a third sub-portion, and a fourth sub-portion. The first sub-portion and the third sub-portion are separately arranged on two sides of the central area in a first direction, and the second sub-portion and the fourth sub-portion are separately arranged on the other two sides of the central area in a second direction. The first direction is different from the second direction.

In Step 703, a gate is formed on the active area, which extends in a first direction and covers at least a part of the central area, at least a part of the first sub-portion, and at least a part of the third sub-portion.

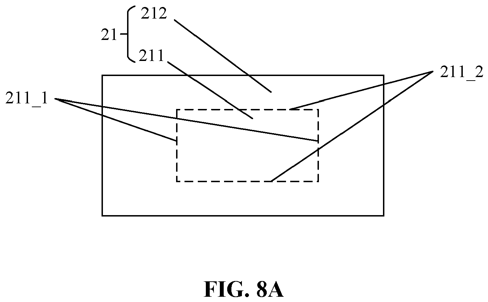

The method for manufacturing a semiconductor device according to the embodiments of the present disclosure will be described in further detail below with reference to FIGS. 8A-8E.

Firstly, as illustrated in FIG. 8A, Step 701 is performed to provide a semiconductor substrate and define an active area 21 including a central area 211 and a peripheral area 212 surrounding the central are 211 in the semiconductor substrate.

In one embodiment, the definition of the active area 21 in the semiconductor substrate includes the following step.

A shallow trench isolation structure (not illustrated) is formed in the semiconductor substrate to define the active area 21.

The material of the semiconductor substrate may be single crystal silicon (Si), silicon on insulator (SOI), or may be other materials, such as Group III-V compounds such as gallium arsenide.

In some embodiments, the central area 211 is rectangular. As illustrated in FIG. 8A, the central area 211 includes a first set of parallel side edges 211_1 parallel to the first direction and a second set of parallel side edges 211_2 parallel to the second direction. It should be noted that, in some other embodiments, the central area 211 may also be in other shapes, such as circular, elliptical, or other polygons other than rectangular.

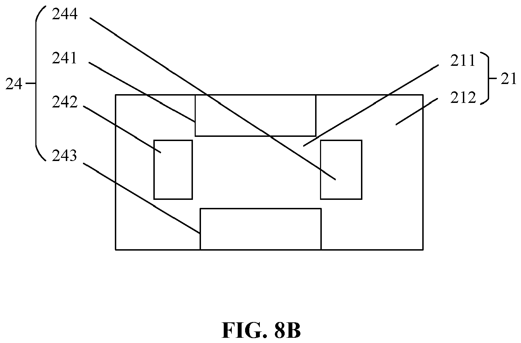

Next, as illustrated in FIG. 8B, Step 702 is performed to form a first strained layer 24 in an embedded manner in the peripheral area 212.

In one embodiment, forming the first strained layer 24 include the following step.

A first trench is formed in the peripheral area 212, and the first strained layer is formed in the first trench by an epitaxial growth process.

It will be appreciated that the first strained layer 24 may also be formed by other means, for example by doping the semiconductor substrate.

In one embodiment, the first strained layer 243 includes at least a first sub-portion 241, a second sub-portion 242, a third sub-portion 243, and a fourth sub-portion 244. The first sub-portion 241 and the third sub-portion 243 are separately arranged on two sides of the central area in a first direction, and the second sub-portion 242 and the fourth sub-portion 244 are separately arranged on the other two sides of the central area in a second direction. The first direction is different from the second direction.

In one embodiment, the first sub-portion 241 and the third sub-portion 243 are symmetrical along the center line of the first set of parallel sides 211_1, and the second sub-portion 242 and the fourth sub-portion 244 are symmetrical along the center line of the second set of parallel sides 211_2.

In some embodiments, the first sub-portion 241, the second sub-portion 242, the third sub-portion 243, and the fourth sub-portion 244 are sequentially connected to form a ring structure surrounding the central area 211. Specifically, both ends of the first sub-portion 241 are respectively connected in contact with one end of the second sub-portion 242, and both ends of the third sub-portion 243 are respectively connected in contact with the other end of the second sub-portion 242 and the other end of the fourth sub-portion 244. The first strained layer 24 having a ring structure can apply stress in both directions to the entire channel area, which can further optimize the performance of the semiconductor device compared to the first strained layer having a non-ring structure.

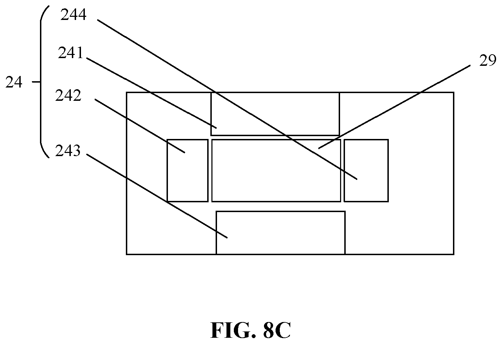

In one embodiment, the method for manufacturing a semiconductor device further includes forming a second strained layer 29 in the central area 211, as illustrated in FIG. 8C.

In one embodiment, the forming of the second strained layer 29 includes the following step.

A second trench is formed in the central area, and the second strained layer is formed in the second trench by an epitaxial growth process.

It will be appreciated that the second strained layer 29 may also be formed by other means, for example by doping the semiconductor substrate.

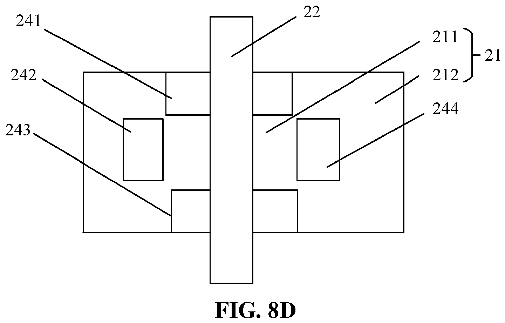

Then, as illustrated in FIG. 8D, Step 703 is performed to form a gate 22 on the active area 21, which extends in a first direction and covers at least a part of the central area 211, at least a part of the first sub-portion 241, and at least a part of the third sub-portion 243.

In one embodiment, the gate 22 also covers at least a part of the second strained layer 29.

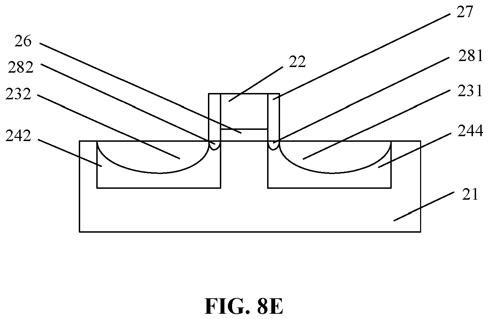

The method for manufacturing a semiconductor device further includes: after forming the gate 22, doping the active area 21 on both sides of the gate 22 to form a first source/drain area 231, a first source/drain extension area 281, a second source/drain area 232, and a second source/drain extension area 282, as illustrated in FIG. 8E.

In one embodiment, the first source/drain area 231 and the first source/drain extension area 28 at least partially coincide with the fourth sub-portion 244, and the second source/drain area 232 and the second source/drain extension area 282 at least partially coincide with the second sub-portion 242.

In one embodiment, the method for manufacturing a semiconductor device further includes the step of forming sidewalls on both sides of the gate 22, as illustrated in FIG. 8E.

The above descriptions are merely preferred embodiments of the present disclosure and are not intended to limit the protection scope of the present disclosure. Any modifications, equivalent replacements and improvements made within the spirit and principles of the present disclosure shall be included within the protection scope of the present disclosure.

## Claims

1. A semiconductor device, comprising:
an active area, located in a semiconductor substrate, comprising a central area and a peripheral area surrounding the central area;
a first strained layer, formed in the peripheral area in an embedded manner, wherein the first strained layer comprises at least a first sub-portion, a second sub-portion, a third sub-portion, and a fourth sub-portion, wherein the first sub-portion and the third sub-portion are separately arranged on two sides of the central area in a first direction, and the second sub-portion and the fourth sub-portion are separately arranged on other two sides of the central area in a second direction, wherein the first direction is different from the second direction; and
a gate, located on the active area, extending in the first direction and covering at least a part of the central area, at least a part of the first sub-portion, and at least a part of the third sub-portion.

2. The semiconductor device according to claim 1, wherein the central area is rectangular, and comprises a first set of parallel side edges parallel to the first direction and a second set of parallel side edges parallel to the second direction.

3. The semiconductor device according to claim 2, wherein the first sub-portion and the third sub-portion are symmetrical along a center line of the first set of parallel sides, and the second sub-portion and the fourth sub-portion are symmetrical along a center line of the second set of parallel sides.

4. The semiconductor device according to claim 1, wherein the first sub-portion, the second sub-portion, the third sub-portion, and the fourth sub-portion of the first strained layer are sequentially connected to form a ring structure surrounding the central area.

5. The semiconductor device according to claim 4, wherein both ends of the first sub-portion are respectively connected and in contact with one end of the second sub-portion and one end of the fourth sub-portion, and both ends of the third sub-portion are respectively connected and in contact with another end of the second sub-portion and another end of the fourth sub-portion.

6. The semiconductor device according to claim 1, wherein the second sub-portion and the fourth sub-portion are symmetrically distributed on both sides of the gate.

7. The semiconductor device according to claim 1, wherein the first strained layer comprises a silicon germanium layer.

8. The semiconductor device according to claim 1, wherein the first strained layer is formed using an epitaxial growth process.

9. The semiconductor device according to claim 1, further comprising a second strained layer located in the central area.

10. The semiconductor device according to claim 9, wherein a thickness of the first strained layer is greater than a thickness of the second strained layer.

11. The semiconductor device according to claim 10, wherein the thickness of the first strained layer is 5-10 times the thickness of the second strained layer.

12. The semiconductor device according to claim 1, comprising a first source/drain area and a second source/drain area, wherein the first source/drain area at least partially coincides with the fourth sub-portion, and the second source/drain area at least partially coincides with the second sub-portion.

13. The semiconductor device according to claim 12, further comprising: a first source/drain extension area having a doping depth less than a doping depth of the first source/drain area, wherein the first source/drain extension area is located between a channel below the gate and the first source/drain area, and at least partially coincides with the fourth sub-portion.

14. The semiconductor device according to claim 12, further comprising: a second source/drain extension area having a doping depth less than a doping depth of the second source/drain area, wherein the second source/drain extension area is located between a channel below the gate and the second source/drain area, and at least partially coincides with the second sub-portion.

15. The semiconductor device according to claim 1, wherein the semiconductor substrate is an n type substrate, and the semiconductor device is a PMOS transistor.

16. The semiconductor device according to claim 1, comprising a shallow trench isolation structure located in the semiconductor substrate to define the active area.

17. A method for manufacturing a semiconductor device, comprising:
providing a semiconductor substrate, and defining an active area in the semiconductor substrate, wherein the active area comprises a central area and a peripheral area surrounding the central area;
forming a first strained layer in the peripheral area in an embedded manner, wherein the first strained layer comprises at least a first sub-portion, a second sub-portion, a third sub-portion, and a fourth sub-portion, wherein the first sub-portion and the third sub-portion are separately arranged on two sides of the central area in a first direction, and the second sub-portion and the fourth sub-portion are separately arranged on other two sides of the central area in a second direction, wherein the first direction is different from the second direction; and
forming a gate on the active area, wherein the gate extends in a first direction and covers at least a part of the central area, at least a part of the first sub-portion, and at least a part of the third sub-portion.

18. The method for manufacturing a semiconductor device according to claim 17, wherein the forming a first strained layer in the peripheral area in an embedded manner comprises:
forming a first trench in the peripheral area, and forming the first strained layer in the first trench by an epitaxial growth process.

19. The method for manufacturing a semiconductor device according to claim 17, further comprising: forming a second strained layer in the central area, wherein the forming a second strained layer comprises:
forming a second trench in the central area, and forming the second strained layer in the second trench by an epitaxial growth process.

20. The method for manufacturing a semiconductor device according to claim 17, further comprising: doping the active area on both sides of the gate to form a first source/drain area, a first source/drain extension area, a second source/drain area, and a second source/drain extension area, wherein the first source/drain area and the first source/drain extension area at least partially coincide with the fourth sub-portion, and the second source/drain area and the second source/drain extension area at least partially coincide with the second sub-portion.

21. The method for manufacturing a semiconductor device according to claim 20, wherein the defining an active area in the semiconductor substrate comprises:
forming a shallow trench isolation structure in the semiconductor substrate to define the active area.
